# EUROPEAN PATENT SPECIFICATION

(11) **EP 3 222 471 B1**
(45) Date of publication and mention of the grant of the patent: **15.08.2018**
(21) Application number: 15860821.6
(22) Date of filing: 30.06.2015
(51) Int. Cl.: B60R 16/027, B60R 16/02, B62D 1/04

(54) **INPUT DEVICE AND INPUT METHOD THEREFOR**
EINGABEVORRICHTUNG UND VERFAHREN DAFÜR
DISPOSITIF D'ENTRÉE ET PROCÉDÉ D'ENTRÉE POUR CELUI-CI

(30) Priority: 19.11.2014 JP 2014234568
(43) Date of publication of application: 27.09.2017
(73) Proprietor: Panasonic Intellectual Property Management Co., Ltd., Osaka-shi, Osaka 540-6207 (JP)
(72) Inventor: NISHIO, Tsuyoshi, Osaka-shi, Osaka 540-6207 (JP); OKAYAMA, Motoyuki, Osaka-shi, Osaka 540-6207 (JP); TADA, Masaki, Osaka-shi, Osaka 540-6207 (JP); SAKAGUCHI, Baku, Osaka-shi, Osaka 540-6207 (JP)
(74) Representative: Vigand, Philippe
(86) International application number: PCT/JP2015/003276
(87) International publication number: WO 2016/079904

(56) References cited:
- EP-A2- 2 783 893
- WO-A1-2013/101029
- WO-A1-2014/021063
- WO-A1-2014/112397
- JP-A- 2013 079 054
- JP-A- 2013 203 193
- JP-A- 2014 043 232
- JP-A- 2014 139 042
- JP-A- 2014 211 690
- US-A1- 2011 292 268

## Description

### TECHNICAL FIELD

The present invention relates to an input device and an input method for the input device, which are used in, for example, a vehicle.

### BACKGROUND ART

An input device has been used for operating vehicle functions including an on-vehicle audio. Since such an input device is often provided between a driver's seat and a front passenger's seat, the input device might sometimes require a driver to change his or her posture from his or her driving posture for operation.

To solve this problem, an input device disposed on a rim (circular part) of a steering wheel for operating vehicle functions has been proposed (for example, Patent Literatures 1 and 2). This helps a driver to operate the vehicle functions while holding the steering wheel for driving.

### Citation List

### Patent Literature

PTL 1: Unexamined Japanese Patent Publication No. 2008-87566
PTL 2: Unexamined Japanese Patent Publication No. 2013-79052

### SUMMARY OF THE INVENTION

An input device according to the present invention includes an operation part, an operation commencement trigger part, and a detection circuit. The operation part is provided on a surface of the circular part of a steering wheel and includes a slider of an electrostatic capacity type.
The operation commencement trigger part is provided at a predetermined location on the slider. The operation commencement trigger part is provided to commence a first operation including a flick operation on the slider. Upon detecting that the operation commencement trigger part has been touched, the detection circuit enables detection of the first operation on the slider, whereby the slider includes a plurality of elements each for detecting an electrostatic capacitance. The detection unit detects that the first operation has finished when, among the plurality of elements, at least a predetermined number of elements has approximately simultaneously detected an electrostatic capacitance equal to or greater than a threshold for a second predetermined period of time. In addition, the present invention relates to an input method for an input device including an operation provided on a surface of the circular part of a steering wheel and including a slider having a plurality of elements each for detecting an electrostatic capacity type and an operation commencement trigger part provided at a predetermined location on the slider. The input method includes A) detecting whether the operation commencement trigger part has been touched, and B) enabling detection of a first operation on the slider when a fact that the operation commencement trigger part has been touched is detected, and C) detecting that the first operation has finished when, among the plurality of elements, at least a predetermined number of elements has approximately simultaneously detected an electrostatic capacitance equal to or greater than a threshold for a second predetermined period of time. With the input device and the input method according to the present invention, even when a driver performs an input operation while holding a steering wheel, an erroneous input can be reduced.

### BRIEF DESCRIPTION OF DRAWINGS

FIG. 1 is a view illustrating an example of a vehicle including an input device according to an exemplary embodiment of the present invention.
FIG. 2 is a view illustrating an example when a driver is sitting on a seat and holding a steering wheel of the vehicle including the input device according to the exemplary embodiment of the present invention.
FIG. 3 is a view illustrating an example of the input device according to the exemplary embodiment of the present invention.
FIG. 4 is a block diagram illustrating a functional configuration of an on-vehicle device and a touch sensor mounted to the vehicle including the input device according to the exemplary embodiment of the present invention.
FIG. 5A is a view illustrating another example of the input device according to the exemplary embodiment of the present invention.
FIG. 5B is a view illustrating an example when the driver grips a grip sensor of the steering wheel shown in FIG. 5A.
FIG. 6A is a view illustrating an example of an appearance of a touch sensor of the input device according to the exemplary embodiment of the present invention.
FIG. 6B is a view illustrating an example of an appearance of another touch sensor of the input device according to the exemplary embodiment of the present invention.
FIG. 7 is a view illustrating a configuration example of the touch sensor of the input device according to the exemplary embodiment of the present invention.
FIG. 8A is a view for illustrating a method for detecting an operation on a slider of the input device according to the exemplary embodiment of the present invention.
FIG. 8B is a graph illustrating a chronological characteristic of an operation at a finger (thumb) detection location on the slider of the input device according to the exemplary embodiment of the present invention.
FIG. 9 is a view illustrating an example when the driver wholly grips the touch sensor of the input device according to the exemplary embodiment of the present invention.
FIG. 10 is a view illustrating an example when a thumb touches a plurality of elements of the touch sensor of the input device according to the exemplary embodiment of the present invention.
FIG. 11 is a flowchart illustrating an example of an input method for the input device according to the exemplary embodiment of the present invention.
FIG. 12A is a flowchart illustrating a process example for activating the touch sensor of the input device according to the exemplary embodiment of the present invention.
FIG. 12B is a flowchart illustrating another process example for activating the touch sensor of the input device according to the exemplary embodiment of the present invention.
FIG. 13 is a flowchart illustrating an example of a switching process for the touch sensor of the input device according to the exemplary embodiment of the present invention.
FIG. 14 is a flowchart illustrating an example of a sliding process for the touch sensor of the input device according to the exemplary embodiment of the present invention.
FIG. 15 is a flowchart illustrating an example of a gripping process for the touch sensor of the input device according to the exemplary embodiment of the present invention.
FIG. 16A is a view illustrating an example of a steering wheel provided with the touch sensor of the input device according to the exemplary embodiment of the present invention.
FIG. 16B is a view illustrating a positional relationship between the touch sensor of the input device according to the exemplary embodiment of the present invention and the steering wheel, respectively shown in FIG. 16A.
FIG. 17A is a view illustrating an example when a flick operation is performed on a touch sensor of the input device according to the exemplary embodiment of the present invention.
FIG. 17B is a view illustrating an appearance of the touch sensor shown in FIG. 17A.

### DESCRIPTION OF EMBODIMENT

Prior to describing an exemplary embodiment of the present invention, problems in a conventional configuration will now be described.

In Patent Literature 1, a ring-shaped input area, and an exclusive area adjacent to the input area are provided on a rim (circular part) of a steering wheel. When a driver has touched the exclusive area, the input area is deactivated against any inputs. However, while the driver is turning the steering wheel, the driver is likely to unintentionally touch the input area, which could result in an erroneous input.

In Patent Literature 2, a matrix-shaped touch sensor is provided on a rim (circular part) of a steering wheel. With a movement of a tip of a finger or thumb in an arc shape, which is estimated based on any detected gripping location, a driver is able to touch-input an operation without visual confirmation. However, in an input device disclosed in Patent Literature 2, a location within the touch sensor, at which the driver has first touched with a tip of his or her finger or thumb, is regarded as a start location of the above described input on the touch sensor. Such a start location has not sometimes been intended by the driver, which could result in an erroneous input.

A configuration for solving such problems will now be described hereinafter.

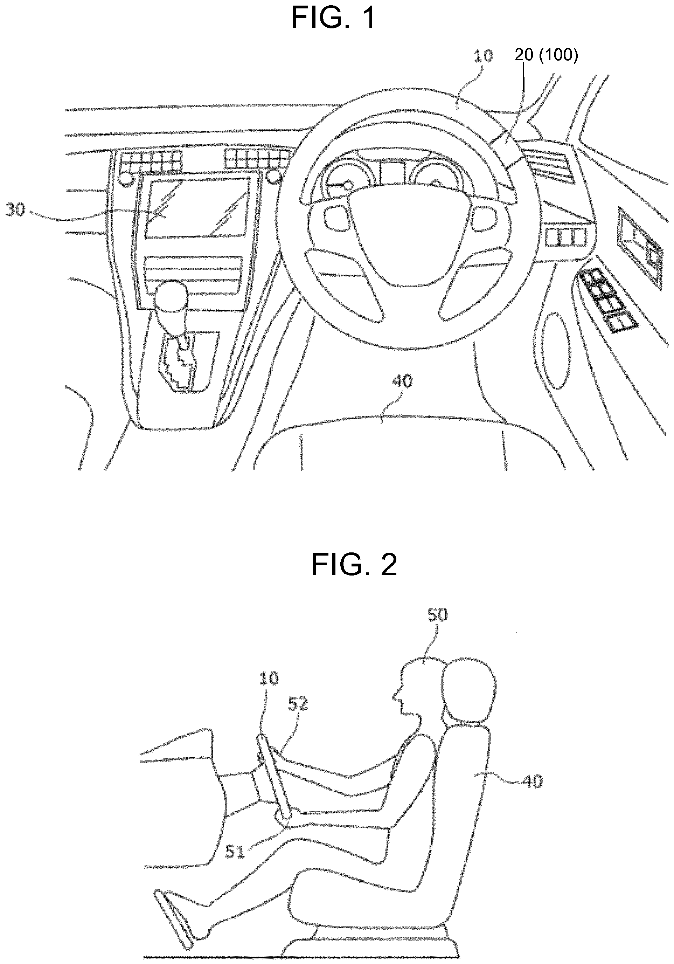

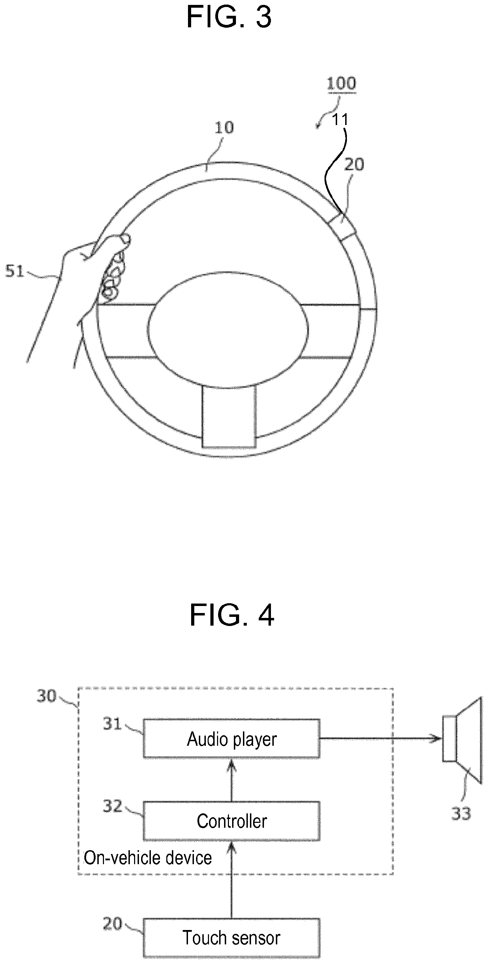

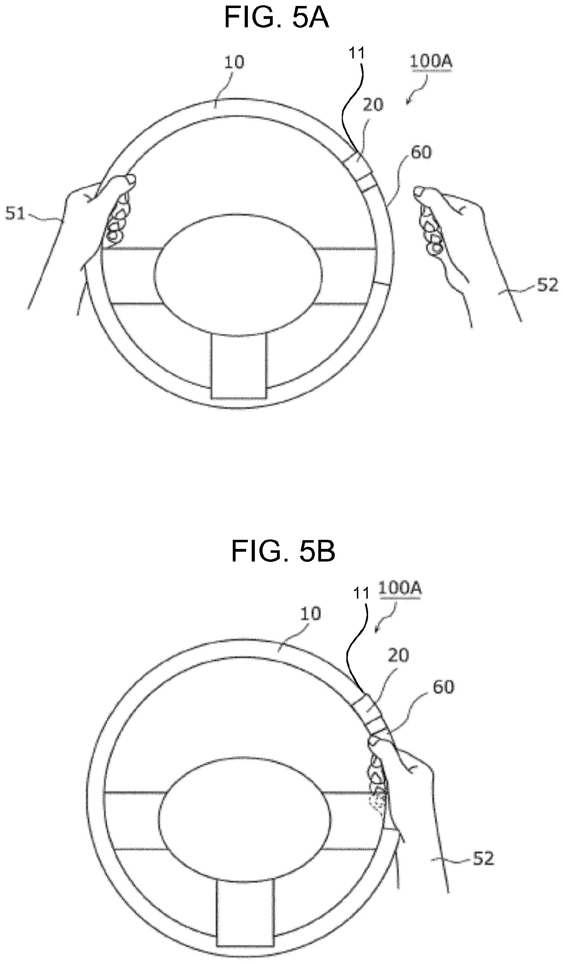

FIG. 1 is a view illustrating an example of a vehicle including input device 100 according to an exemplary embodiment of the present invention. FIG. 2 is a view illustrating an example when a driver is sitting on a seat and holding a steering wheel of the vehicle including input device 100 according to the exemplary embodiment of the present invention. FIG. 3 is a view illustrating an example of input device 100. FIG. 4 is a block diagram illustrating a functional configuration of an on-vehicle device and a touch sensor mounted to the vehicle including input device 100. FIG. 5A is a view illustrating input device 100A. FIG. 5B is a view illustrating an example when the driver grips a grip sensor of input device 100A of the steering wheel shown in FIG. 5A.

The vehicle shown in FIG. 1 includes steering wheel 10, touch sensor 20, on-vehicle device 30, and seat 40. Input device 100 includes touch sensor 20 provided on a part of steering wheel 10.

Steering wheel 10 of the vehicle includes a ring-shaped part (rim). When steering wheel 10 is turned, a travel direction of the vehicle is adjusted. As shown in FIG. 2, steering wheel 10 is held by hands 51 and 52 of driver 50.

As shown in FIG. 3, touch sensor 20 is provided on a surface of the circular part of steering wheel 10. According to such a configuration, steering wheel 10 including the circular part is an operation part including touch sensor 20 for accepting input operations. Touch sensor 20 is covered with cover 11 made of a synthetic resin, such as urethane, or leather. Cover 11 may be configured to cover a whole circumference of steering wheel 10, or may be fixed to steering wheel 10 so as to cover only an upper surface of touch sensor 20. The latter configuration is applied here.

When steering wheel 10 is placed at a neutral position as shown in FIG. 3, touch sensor 20 is provided at a predetermined location on the circular part. Touch sensor 20 has been achieved with an electrostatic capacity type. Touch sensor 20 may be achieved with a resistance film type, and is not always limited to an electrostatic capacity type. With an electrostatic capacity type, even though touch sensor 20 is covered with cover 11, an electrostatic capacitance changes depending on a distance between touch sensor 20 and a finger or thumb of driver 50. Therefore, without being affected by cover 11, by comparing an electrostatic capacitance and a predetermined threshold, whether a finger or thumb has been touched onto touch sensor 20 can precisely and easily be determined. Therefore, in this exemplary embodiment, touch sensor 20 has been achieved with an electrostatic capacity type. In this context, touch sensor 20 having a characteristic where the closer a distance between touch sensor 20 and a finger or thumb, the greater an electrostatic capacitance is used. Therefore, when a finger or thumb is far from touch sensor 20, an electrostatic capacitance is less than a threshold, and, upon a finger or thumb touches touch sensor 20, an electrostatic capacitance exceeds the threshold. However, touch sensor 20 may have another characteristic, opposite to the above described characteristic. That is, when a finger or thumb is away from touch sensor 20, an electrostatic capacitance exceeds a threshold, and, upon a finger or thumb touches touch sensor 20, an electrostatic capacitance is less than the threshold. Other details will be described later, thus are omitted here.

On-vehicle device 30 is, for example, an audio device. In this exemplary embodiment, with on-vehicle device 30, the audio device is operated in accordance with an input operation on touch sensor 20. In an example shown in FIG. 4, on-vehicle device 30 includes audio player 31 and controller 32.

In accordance with a control of controller 32, audio player 31 selects and plays an audio signal to cause external loudspeaker 33 to sound. Audio player 31 plays an audio signal selected, in accordance with a control of controller 32, from a plurality of audio signals stored in, for example, an optical disc or a semiconductor memory. In addition, audio player 31 plays an audio signal of a radio station selected, in accordance with a control of controller 32, from radio stations, for example. Controller 32 controls audio player 31 in accordance with an input operation on touch sensor 20.

Seat 40 shown in FIG. 2 is provided for driver 50 driving the vehicle.

An input device according to this exemplary embodiment is not limited to input device 100 shown in FIGS. 1 and 3. For example, as shown in FIGS. 5A and 5B, input device 100A includes grip sensor 60 in addition to touch sensor 20. Grip sensor 60 functions as a sensor for detecting a fact in which driver 50 has gripped steering wheel 10.

As shown in FIGS. 5A and 5B, grip sensor 60 is provided at a location where driver 50 grips the circular part in a normal posture when steering wheel 10 is placed at the neutral position. In this context, in order to prevent an output signal of touch sensor 20 and an output signal of grip sensor 60 from mixing, grip sensor 60 is disposed at a different location on the circular part from a location on a slider configuring touch sensor 20. Details of the slider will be described later. In addition, grip sensor 60 may be finished in a manner similar to touch sensor 20, that is, cover 11 made of a synthetic resin, such as urethane, or leather, may cover a whole circumference of steering wheel 10 including grip sensor 60. Otherwise, cover 11 may cover only a surface of grip sensor 60. The latter configuration is applied here.

Input device 100A may activate touch sensor 20 when grip sensor 60 has detected a fact in which driver 50 has gripped steering wheel 10.

Next, a configuration of touch sensor 20 will now be described.

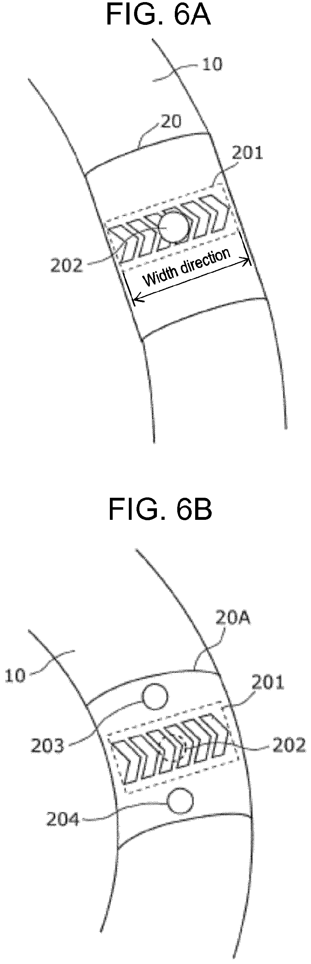

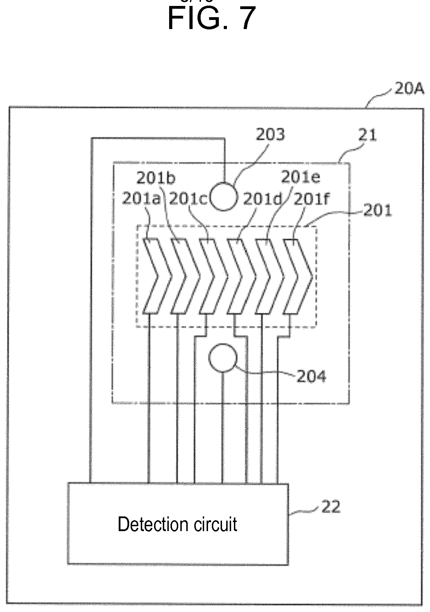

FIG. 6A is a view illustrating an example of an appearance of touch sensor 20. FIG. 6B is another view illustrating an example of an appearance of touch sensor 20A. FIG. 7 is a view illustrating a configuration example of touch sensor 20A.

Touch sensor 20 includes, for example, as shown in FIG. 6A, slider 201, and home location identification part (operation commencement trigger part) 202. Similar to touch sensor 20A shown in FIG. 6B, for example, switch 203 and switch 204 may further be included. Although switch 203 and switch 204 are not an essential configuration, an example where input device 100 is provided with touch sensor 20A will now be described below.

In this exemplary embodiment, touch sensor 20A includes, for example, as shown in FIG. 7, touch sensor area 21, and detection circuit 22.

Detection circuit 22 is electrically coupled to each of a plurality of elements, switch 203, and switch 204 to detect a respective electrostatic capacitance. In this exemplary embodiment, detection circuit 22 detects electrostatic capacitances of the plurality of elements, switch 203, and switch 204 while performing a scan in a single direction in a time division manner. In other words, detection circuit 22 detects in a time division manner electrostatic capacitances or change values of elements, which is generated when a driver touches with his or her finger or thumb the elements of slider 201. Therefore, detection circuit 22 can detect an operation (first operation) including a flick operation and a slide operation on slider 201.

Note that touch sensor 20A may include touch sensor area 21 only, and may not include detection circuit 22. In addition, each of slider 201, switch 203, and switch 204 may include a function of detection circuit 22. Alternatively, slider 201, switch 203, and switch 204 respectively are elements provided in touch sensor area 21 for detecting electrostatic capacitances, and detection circuit 22 may otherwise be provided separately.

Slider 201 is provided in touch sensor 20A, as shown in FIG. 6B, to detect a flick operation or a slide operation (first operation). More specifically, slider 201 is disposed at a predetermined location on the circular part when steering wheel 10 is placed at the neutral position. Slider 201 extends in a direction substantially perpendicular to a direction toward which the circular part turns. With this arrangement, slider 201 detects a first operation performed by driver 50 with his or her thumb. The substantially perpendicular direction is defined to a perpendicular direction in a range, where driver 50 can easily perform the first operation with his or her thumb having an average length when driver 50 is about to perform a first operation on slider 201.

Upon detecting that home location identification part 202 has been touched, detection circuit 22 enables detection of a first operation on slider 201.

In addition, slider 201 includes a plurality of elements each for detecting an electrostatic capacitance. The plurality of elements is disposed side by side, as shown in FIGS. 6A and 6B, in the direction substantially perpendicular to the direction toward which the circular part of steering wheel 10 lies in a circle. The plurality of elements respectively functions as touch sensors. A shape of each of the plurality of elements is not limited to a "V"-shape, but may be a rectangular shape or an arc shape.

FIG. 7 shows an example where six elements are provided in slider 201. In other words, FIG. 7 shows an example when slider 201 includes six elements: element 201a, element 201b, element 201c, element 201d, element 201e, and element 201f. However, the number of elements is not limited to six, but may be more or less than six. However, if the number of elements is fewer, such as one, two, or three, a flick operation or a slide operation could not fully be detected. Therefore, the number of elements should substantially be four or more.

Home location identification part 202 is an example of an operation commencement trigger part, and is provided at a predetermined location on slider 201. The predetermined location on slider 201 is a center position of slider 201 in a direction toward which driver 50 moves his or her finger or thumb, which is a width direction of slider 201 shown in FIG. 6A. Home location identification part 202 is regarded as a trigger (start point) for commencing an operation (first operation) including a flick operation on slider 201.

Therefore, on slider 201, the elements are disposed in an area of which lengths are approximately identical in the width direction from home location identification part 202. As a result, when a flick operation is performed in either direction from home location identification part 202, an equivalent input can be detected.

In addition, at a location of home location identification part 202 disposed on touch sensor 20A, at least one of an uneven part, an illumination part, and a different tactile part from other parts of touch sensor 20A may advantageously be provided. Specifically, the uneven part can be configured by providing a protrusion at the location of home location identification part 202 disposed on touch sensor 20A. The illumination part can be configured by disposing a chip LED at the location of home location identification part 202 disposed on touch sensor 20A. The different tactile part can be configured by altering a material at the location of home location identification part 202 disposed on touch sensor 20A to a softer or harder material than a material used in other parts of touch sensor 20A. Therefore, driver 50 can promptly recognize home location identification part 202 with his or her eye or a tip of his or her finger or thumb.

In addition, cover 11 for covering touch sensor 20A may further be provided. Although cover 11 is omitted in FIGS. 6A and 6B for simply describing touch sensor 20A, cover 11 actually covers touch sensor 20A as shown in FIG. 3. At a location of cover 11 covering home location identification part 202, at least one of an uneven part, an illumination part, and a different tactile part from other parts of cover 11 is provided. Specifically, the uneven part is configured by providing a protrusion at the location of cover 11 covering home location identification part 202. The illumination part can be configured by reducing a thickness at the location of cover 11 covering home location identification part 202 to an extent that light can transmit, and disposing a chip LED immediately below cover 11. The different tactile part can be configured by altering a material at the location of cover 11 covering home location identification part 202 to a softer or harder material than a material used in other parts of cover 11. Therefore, driver 50 can promptly recognize home location identification part 202 with his or her eye or a tip of his or her finger or thumb.

Two or more of the above-described uneven part, illumination part, and different tactile part may simultaneously be provided. In this case, driver 50 can more easily identify home location identification part 202.

In addition, home location identification part 202 includes, among the plurality of elements configuring slider 201, at least one element belonging to an area including the predetermined location of slider 201, for example, the center position of slider 201 in the width direction. Home location identification part 202 is provided at a center of slider 201 in the width direction when slider 201 is attached in a direction substantially perpendicular to a circumferential direction of the circular part of steering wheel 10. Therefore, when an electrostatic capacitance equal to or greater than a threshold is detected in at least one element, detection circuit 22 can detect a fact in which driver 50 has touched home location identification part 202 with a tip of his or her finger or thumb, based on a location of the element that shows the value. Alternatively, detection circuit 22 may detect a fact in which home location identification part 202 has been touched when an electrostatic capacitance equal to or greater than a threshold for a predetermined period of time or longer is detected in an element located on home location identification part 202.

Each of switches 203 and 204 accepts an operation (second operation) including a tap operation. Switches 203 and 204 include electrostatic capacity-type touch sensors, respectively, disposed at predetermined locations away from an operation commencement trigger part (home location identification part 202) in the circumferential direction of the circular part of steering wheel 10. Therefore, switches 203 and 204 respectively can accept an input operation (second operation) such as a touch input and a tap input. Switches 203 and 204 are provided, for example, as shown in FIG. 6B, at predetermined locations above and below home location identification part 202 in the circumferential direction of the circular part of steering wheel 10. The predetermined locations are defined to respective locations of switches 203 and 204 where driver 50 can easily reach with a tip of his or her finger or thumb when driver 50 has stretched, or bent, the finger or thumb from home location identification part 202 (for example, in a range from 1 cm to 1.5 cm, inclusive).

Cover 11 made of urethane or leather served as a surface of steering wheel 10 covers switches 203 and 204. On the surface of cover 11 at the respective locations of switch 203 and switch 204, similar to home location identification part 202, at least one of an uneven part, an illumination part, and a different tactile part is provided. Therefore, driver 50 can promptly recognize touch switch 203 and switch 204 visually or in tactile impression.

Switches 203 and 204 may be used for switching a sound source for audio player 31 in FIG. 4. Alternatively or additionally, switches 203 and 204 may be used for adjusting a volume of sound at which audio player 31 plays.

Next, an operation of slider 201 will be described hereinafter.

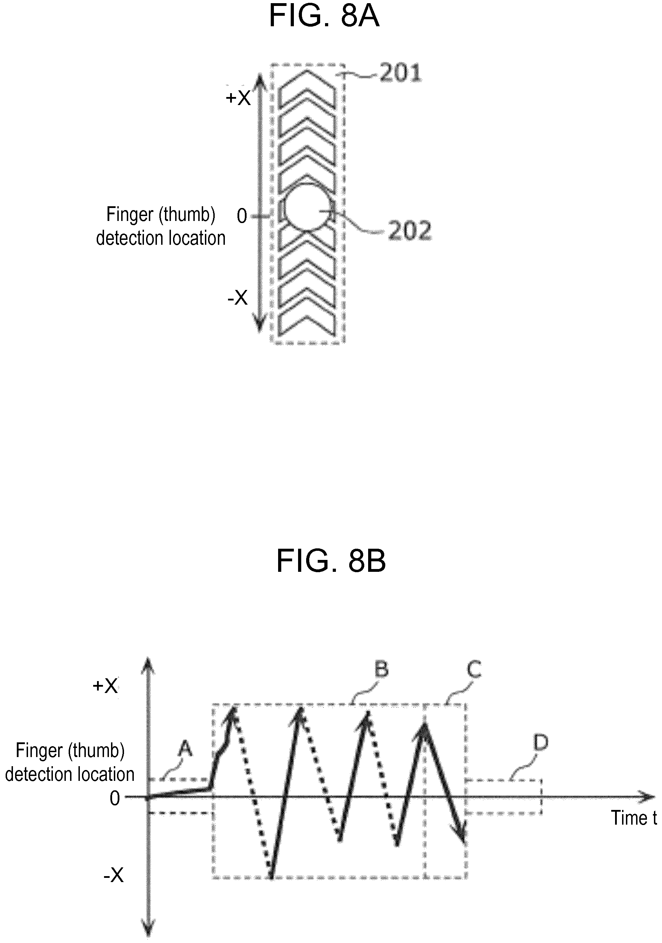

FIG. 8A is a view illustrating a method for detecting an operation on slider 201. FIG. 8B is a graph illustrating a chronological characteristic of an operation at a finger (thumb) detection location of slider 201. FIG. 8A shows elements included in slider 201 and coordinates of the elements. Home location identification part 202 lies at a location where a coordinate is 0, which is a center of slider 201. In FIG. 8A, respective coordinates above and below home location identification part 202 are shown with +X and -X. Each of these coordinates indicates a finger (thumb) detection location. In FIG. 8B, a horizontal axis shows time t, while a vertical axis shows finger (thumb) detection location X. FIG. 8B shows a chronological characteristic at a finger (thumb) detection location, where time t when driver 50 has touched home location identification part 202 with his or her finger or thumb is specified to 0, and driver 50 has repeated slide or flick operations with his or her finger or thumb on slider 201 in direction X (in FIG. 8A, upward). Dotted lines in the chronological characteristic shown in FIG. 8B indicate that, for example, driver 50 has moved his or her finger or thumb without touching slider 201 from finger (thumb) detection location +X on slider 201 to finger (thumb) detection location -X. Therefore, since no signal can be obtained from slider 201 in these periods, such movements of a finger or thumb are shown with dotted lines in FIG. 8B.

In FIG. 8B, area A shows a small movement around home location identification part 202. In other words, in area A, a finger or thumb of driver 50 just lies on or around an element of home location identification part 202 of slider 201, and thus it is regarded that no flick operation on slider 201 has been performed. For example, in this case, in a configuration shown in FIG. 4, controller 32 determines that no input operation for audio player 31 is performed on slider 201, and thus does not control audio player 31.

Area B shows that slide or flick operations are repeated on slider 201 by a finger or thumb in a direction toward finger (thumb) detection location +X. In other words, in area B, driver 50 has repeated slide or flick operations with his or her finger or thumb on the plurality of elements of slider 201 shown in FIG. 8A from a lower element to an upper element in order. A slide or flick operation with a finger or thumb on the plurality of elements is referred to as a continuous operation of simultaneously touching and moving the plurality of elements with the finger or thumb. In an example shown in FIG. 8B, driver 50 has repeated four times slide or flick operations. Therefore, in area B, it is regarded that a plurality of flick or slide operations has been performed. Therefore, for example, in the configuration shown in FIG. 4, controller 32 determines that an input operation for audio player 31 has been performed on slider 201. Controller 32 then controls audio player 31, each time a flick operation is performed in direction +X, to advance a track (sound number) in a sound source. Controller 32 identifies, in FIG. 8B, a flick operation starting from either finger (thumb) detection location 0 or any location in direction -X toward direction +X as a single flick operation to control audio player 31.

As described above, when home location identification part 202 is touched and an operation (first operation) is commenced on slider 201, repeated slide or flick operations performed after that are determined as a consecutive operation. At this time, in the consecutive first operation, each operation may not start from home location identification part 202. In other words, unless home location identification part 202 is touched, no consecutive first operation will be identified. Therefore, touch sensor 20A suppresses erroneous inputs by driver 50 and allows driver 50 to smoothly commence and continue a touch-input operation without seeing the input device.

Area C shows that a single slide or flick operation has been performed on slider 201 toward direction -X with a finger or thumb. Therefore, in the configuration shown in FIG. 4, controller 32 determines that an input operation for audio player 31 has been performed on slider 201 in a direction opposite to the direction of the operations performed in area B. Controller 32 controls audio player 31 to select a previous track from the sound source.

Area D shows that no operation is performed on slider 201. In other words, area D shows that neither a finger nor a thumb has been touched on any of the plurality of elements in slider 201. Therefore, in the configuration shown in FIG. 4, controller 32 determines that no input operation for audio player 31 has been performed on slider 201. Furthermore, when controller 32 determines that no input for audio player 31 has been obtained from slider 201 for a certain period of time, controller 32 confirms a currently selected track. Controller 32 then controls audio player 31 to play the confirmed track.

To end or cancel an operation on slider 201, driver 50 may follow a procedure described below. 1) Operate a part or parts other than slider 201, 2) operate nothing for a predetermined period of time, or 3) simultaneously touch a plurality of detection locations, among detection locations of each of switch 203, switch 204, and a plurality of elements included in slider 201.

The procedure will now specifically be described below.

### 1) When a part or parts other than slider 201 is operated

After detection circuit 22 has enabled detection of a first operation on slider 201, and upon detection circuit 22 detects a second operation on switch 203 or switch 204, detection circuit 22 determines that the first operation on slider 201 has finished.

Therefore, for example, while the above described consecutive and repeated first operation is performed, when switch 203 or 204 is pressed as another operation, detection circuit 22 processes that the first operation has finished or been canceled. Another operation is not limited to pressing switch 203 or 204 during a first operation, but may be an operation including touching home location identification part 202, or wholly placing a hand of driver 50 over slider 201.

In a case when, while switch 203 or 204 is pressed, the above described first operation is performed on slider 201, it may also be processed in a similar or identical manner. In other words, when a first operation is performed, an operation of pressing switch 203 or 204 is processed as that the operation has finished or being canceled.

### 2) When no operation is performed for a predetermined period of time

When detection circuit 22 detects electrostatic capacitances smaller than a threshold from all of the plurality of elements configuring slider 201 for a first predetermined period of time or longer, detection circuit 22 performs a process as that a first operation on slider 201 has finished. A first predetermined period of time is used for determining that the first operation has finished, and is referred to as a period of time during which a state continues, where an electrostatic capacitance is smaller than a threshold, such that detection circuit 22 determines that a first operation is not performed. The first predetermined period of time is stored beforehand in detection circuit 22.

### 3) When a plurality of elements is simultaneously touched

When detection circuit 22 approximately simultaneously detects electrostatic capacitances equal to or greater than a threshold from at least a predetermined number of elements in the plurality of elements configuring slider 201 for a second predetermined period of time, detection circuit 22 performs a process as that a first operation has finished. A second predetermined period of time is used for determining that the first operation has finished, and is referred to as a period of time during which a state continues, where an electrostatic capacitance is greater than a threshold such that detection circuit 22 determines that a first operation is performed on a predetermined number of elements. The second predetermined period of time is stored beforehand in detection circuit 22.

Next, a case when detection circuit 22 processes an operation as an invalid operation to avoid erroneous inputs will be described hereinafter.

When detection circuit 22 detects that a plurality of elements on slider 201 exceeding the number of elements that can be touched by a finger or thumb has approximately simultaneously been touched, detection circuit 22 may process the operation on slider 201 as an invalid operation. Therefore, an erroneous input on slider 201 can be reduced.

In this exemplary embodiment, for many detection parts including a plurality of elements, switch 203, and switch 204, detection circuit 22 switches internal switches at a high speed in a range from 1 millisecond to 10 milliseconds to sequentially detect electrostatic capacitances from the plurality of elements. Therefore, detection circuit 22 can detect that, for example, a plurality of elements has approximately simultaneously been touched.

A process for invalidating an operation is not limited to the above described process, but may include other processes. Another aspect of a process for invalidating an operation will be described.

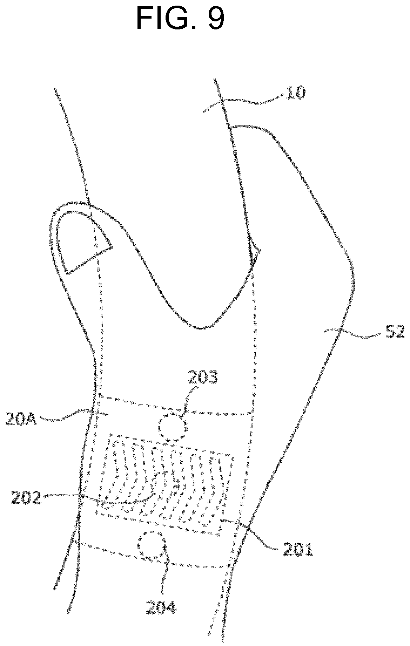

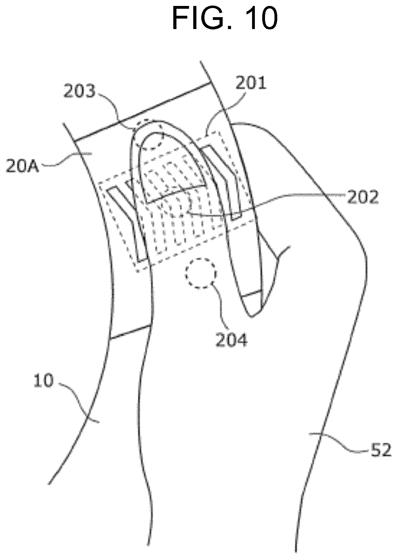

FIG. 9 is a view illustrating an example when driver 50 wholly grips touch sensor 20A. FIG. 10 is a view illustrating an example when a thumb touches a plurality of elements of touch sensor 20A.

Since touch sensor 20A is configured of an electrostatic capacity type, detection circuit 22 can detect a hand, finger, or thumb directly that not only when it touches slider 201, but also when it is close to an area around slider 201. Therefore, even if a hand, finger, or thumb partially floats above a plurality of detection locations, by comparing electrostatic capacitances obtained through elements and a threshold, detection circuit 22 can detect whether a whole area is gripped, or only a tip of a finger or thumb is touched.

### (First exemplary process)

For example, as shown in FIG. 9, when driver 50 wholly covers with his or her hand 52 over touch sensor 20A or slider 201, detection circuit 22 may process an input as an invalid operation to determine that no operation is performed on slider 201. Specifically, detection circuit 22 detects that, on touch sensor 20A, a plurality of elements exceeding the number of elements that can be touched by a finger or thumb is approximately simultaneously touched. In this case, input device 100 determines that driver 50 wholly covers with his or her hand 52 over touch sensor 20A or slider 201, and processes an input as an invalid operation to determine that no operation is performed on slider 201.

When detection circuit 22 detects that a plurality of elements is approximately simultaneously touched as described above, input device 100 or 100A may determine that steering wheel 10 is partially gripped.

### (Second exemplary process)

For example, input device 100A with grip sensor 60 disposed on steering wheel 10 may use grip sensor 60 to perform a process for invalidating an operation.

For example, grip sensor 60 is divided into four parts and disposed on the circular part of steering wheel 10. Therefore, when steering wheel 10 is gripped, grip sensor 60 can identify a location at which steering wheel 10 is gripped.

When driving a vehicle, driver 50 normally grips steering wheel 10, as shown in FIG. 5B, so as to cover grip sensor 60, but so as not to cover touch sensor 20. Therefore, an output of grip sensor 60 in this case is greater enough. Next, when driver 50 turns steering wheel 10, hand 52 moves to a location covering over a part of touch sensor 20. As a result, since grip sensor 60 is not disposed to overlap with touch sensor 20, an area of grip sensor 60 covered by hand 52 reduces, and an output reduces as well. Therefore, the location of hand 52 identified by grip sensor 60 is determined as a location of slider 201 disposed on the circular part. Detection circuit 22 then disables detection of a first operation on slider 201. Therefore, input device 100A can invalidate an unintentional operation of driver 50 on slider 201 or other sensors, and thus a possibility of performing an erroneous input by driver 50 can be lowered.

### (Third exemplary process)

If a speed or a distance of a slide or flick operation with a finger or thumb from home location identification part 202 is equal to or smaller than a certain threshold, input devices 100, 100A may perform an operation invalidating process to invalidate the slide or flick operation on slider 201.

### (Fourth exemplary process)

As shown in FIG. 10, when the plurality of elements of slider 201 and switches 203, 204 are approximately simultaneously touched by a finger or thumb, input devices 100, 100A may perform an operation invalidating process to invalidate an operation on slider 201.

### (Fifth exemplary process)

As described above, grip sensor 60 can detect a first location at which steering wheel 10 is gripped. This can be achieved because the larger an area of hand 52 covering grip sensor 60, the greater an output, while the more a first location of hand 52 is away from grip sensor 60, the smaller an area of hand 52 covering grip sensor 60 and thus the smaller an output. Therefore, when a thumb of hand 52 lies at a second location covering slider 201 as shown in FIG. 10, an area of hand 52 covering the grip sensor 60 reduces accordingly, and thus, based on the first location, an output of grip sensor 60 is smaller. Accordingly, there's an interrelationship between the first location and the second location. The interrelationship between the first location and the second location is stored in detection circuit 22 beforehand. Therefore, based on the first location, the second location can be estimated. When the second location estimated through the interrelationship based on the first location identified by grip sensor 60 is a location at which slider 201 is disposed, detection circuit 22 enables detection of a first operation on slider 201.

This configuration can prevent an unintentional, erroneous operation on switch 203 or switch 204 provided on slider 201 from being detected.

Details will be described below.

When driver 50 grips steering wheel 10, for example, as shown in FIG. 10, slider 201, switch 203, and switch 204 lie in an area between a palm and a thumb tip. In this case, detection circuit 22 might detect a touch on switch 204 and the plurality of elements of slider 201, in addition to switch 203 to which driver 50 is about to operate with the thumb tip.

In this case, in this exemplary process, detection circuit 22 preferentially detects an input operation probably touched with the thumb tip. In other words, detection circuit 22 uses the above described interrelationship to validate the input operation probably touched with the thumb tip, and to invalidate an input operation probably touched with portions including the palm and other than the thumb tip. As described above, by using grip sensor 60, a location of a palm can roughly be identified. Therefore, input device 100A can discriminate a tip of a finger or thumb and another portion including a palm to identify a location of the tip of the finger or thumb. As a result, this exemplary process can be achieved.

When an operation invalidating process described in this exemplary process is to be performed, and when, for example, switch 203 and switch 204 are away from each other, and switch 203 is to be operated with a tip of a finger or thumb, a configuration is assumed, where the plurality of elements and switch 204 are covered with a palm. At this time, detection circuit 22 determines that the tip of the finger or thumb touches switch 203, while the palm covers the plurality of elements and switch 204. Based on this determination, a process is performed where the tip of the finger or thumb and the palm are discriminated, and an operation performed with the tip of the finger or thumb is prioritized. Detection circuit 22 detects a touch with the tip of the finger or thumb preferentially, and disables detection of another touch with the palm. Therefore, even though touches on the plurality of elements and switch 204 lying on an area from the palm to the near location of the tip of the finger or thumb have been detected, detection circuit 22 can discriminate the tip of the finger or thumb and the palm, and perform a process for prioritizing an operation performed by the tip of the finger or thumb.

In addition, in this exemplary process, as an operation invalidating process to prioritize a process for detecting a touch with a tip of a finger or thumb, when touches on the plurality of elements and switch 204 have been detected, detection circuit 22 determines that touch sensor 20A has been gripped. Without invalidating all input operations on touch sensor 20A, detection circuit 22 then validates only an input operation performed on switch 203 with the tip of the finger or thumb. Furthermore, to use touch sensor 20A to perform a grip detection, detection circuit 22 determines whether a plurality of elements that is not lie on the area from the palm to the tip of the finger or thumb has approximately simultaneously been gripped.

### (Sixth exemplary process)

For example, it is assumed a case where driver 50 searches switch 203 with his or her finger or thumb in order to perform a touch input on switch 203 without seeing the input device after driver 50 has touched home location identification part 202.

In this case, a speed or an amount of a flick or slide operation on slider 201 with a tip of a finger or thumb of driver 50 from home location identification part 202 is equal to or smaller than a predetermined threshold. If the value of a speed or a distance of a flick or slide operation is equal to the predetermined threshold or less, it is determined that the operation is unintentional. This threshold is determined by actually measuring beforehand a movement of a tip of a finger or thumb, and is stored in detection circuit 22. When a speed or an amount of a flick or slide operation is equal to or less than the predetermined threshold, and then a touch on switch 203 is detected, detection circuit 22 processes the touch such that switch 203 has been operated. In other words, when a speed or an amount of a slide operation from home location identification part 202 is equal to or less than the predetermined threshold, and then a touch on switch 203 is detected, detection circuit 22 invalidates an operation on slider 201, and validates the operation on switch 203. Therefore, even with a configuration where gaps between slider 201 and each of switches 203 and 204 are smaller, an erroneous input can be reduced.

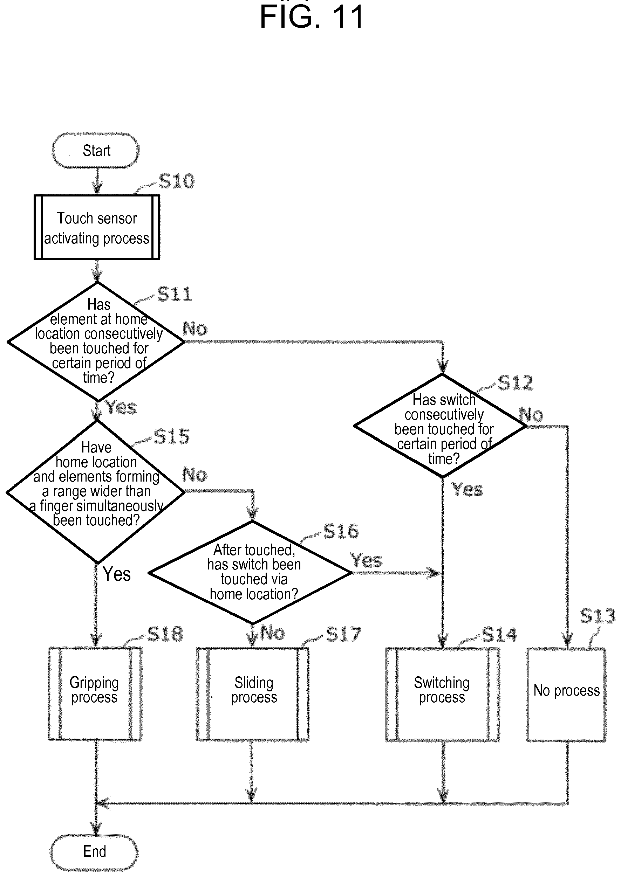

Next, an input method for input device 100A will be described with reference to FIGS. 11 to 14.

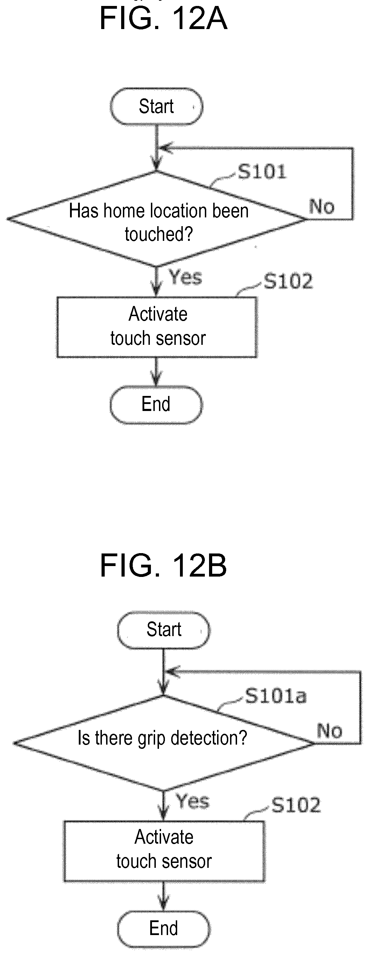

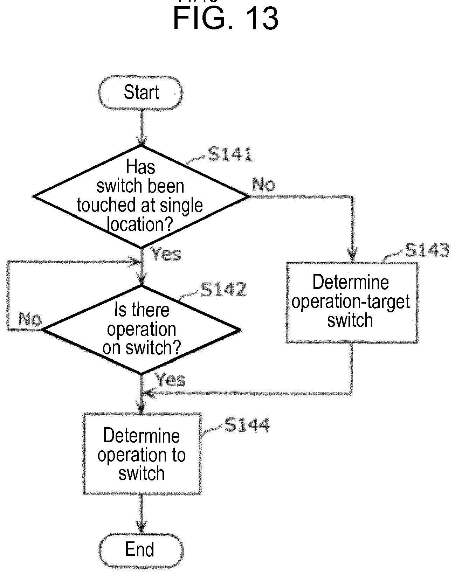

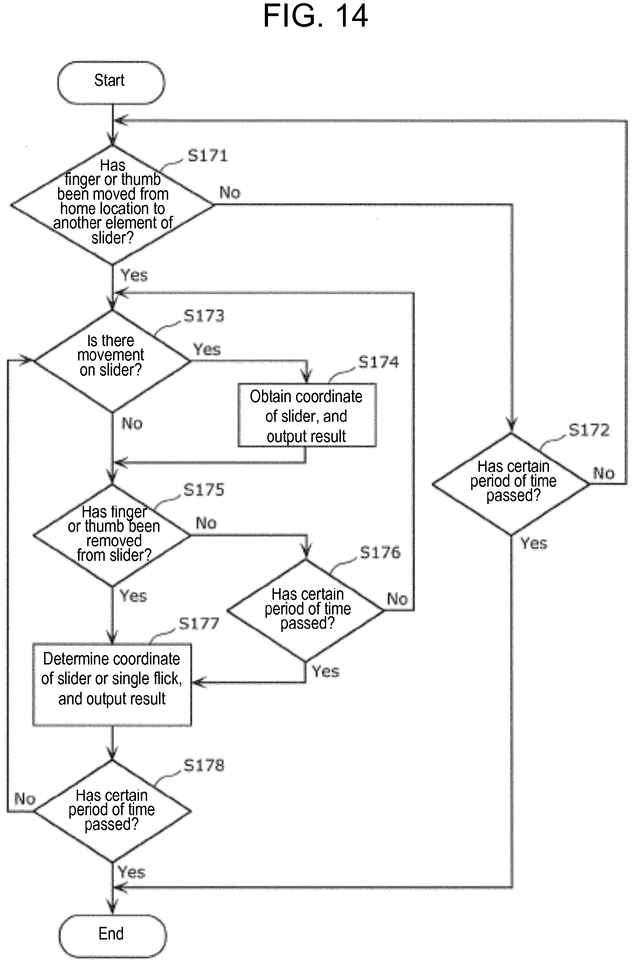

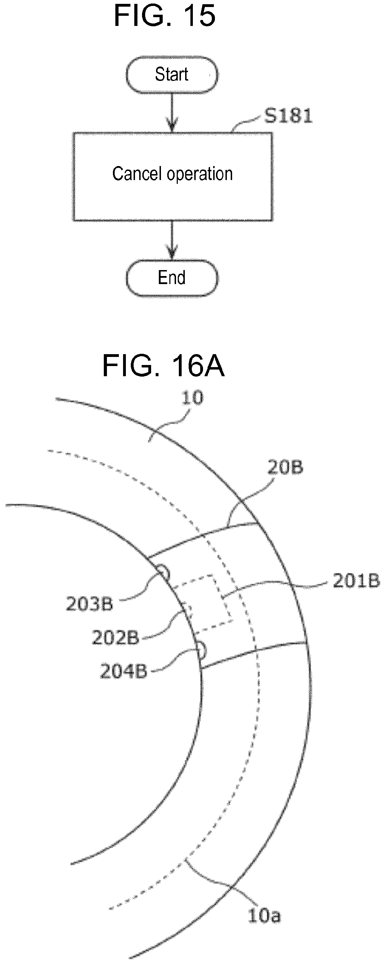

FIG. 11 is a flowchart illustrating an example of an input method for input device 100A. FIG. 12A is a flowchart illustrating an example of a process for activating touch sensor 20A. FIG. 12B is a flowchart illustrating another example of a process for activating touch sensor 20A. FIG. 13 is a flowchart illustrating an example of a switching process for touch sensor 20A. FIG. 14 is a flowchart illustrating an example of a sliding process for touch sensor 20A. FIG. 15 is a flowchart illustrating an example of a gripping process for touch sensor 20A.

In FIG. 11, input device 100A first performs a touch sensor activating process (S10).

Specifically, touch sensor 20A is activated with either method shown in FIG. 12A or 12B. For example, with the method shown in FIG. 12A, input device 100A first detects whether a finger, a thumb, or another object has touched home location identification part 202 (S101). When input device 100A detects that a finger, a thumb, or another object has touched home location identification part 202 (Yes in S101), input device 100A activates touch sensor 20A (S102). When input device 100A has not detected that a finger, a thumb, or another object has touched home location identification part 202 (No in S101), input device 100A returns to the operation of S101 to wait until a finger, a thumb, or another object touches home location identification part 202.

On the other hand, with the method shown in FIG. 12B, for example, based on an output of grip sensor 60, input device 100A detects that steering wheel 10 has been gripped with a hand to activate touch sensor 20A. At this time, input device 100A first detects whether or not steering wheel 10 has been gripped with a hand (S101a) based on an output of grip sensor 60. When input device 100A detects that steering wheel 10 has been gripped with the hand (Yes in S101a), input device 100A activates touch sensor 20A (S102). When input device 100A has not detected that steering wheel 10 has been gripped with a hand (No in S101a), input device 100A returns to the operation of S101a to wait until steering wheel 10 is gripped with a hand.

In this exemplary embodiment, input device 100A enables detection of a first operation on slider 201 and detection of a second operation on switches 203 and 204 to activate touch sensor 20A.

Next, in FIG. 11, input device 100A determines whether or not a finger or thumb is consecutively touching an element configuring home location identification part 202 for a certain period of time (S11).

In S11, when input device 100A determines that a finger or thumb is not consecutively touching the element configuring home location identification part 202 for the certain period of time (No in S11), input device 100A determines whether or not a finger or thumb is consecutively touching switch 203 or 204 for a certain period of time (S12).

In S12, when input device 100A determines that a finger or thumb is not consecutively touching switch 203 or 204 for the certain period of time (No in S12), it can be determined that no input operation has been performed on touch sensor 20A. Therefore, input device 100A performs no process (S13), and ends this input process.

On the other hand, in S12, when input device 100A determines that a finger or thumb is consecutively touching switch 203 or 204 for the certain period of time (Yes in S12), input device 100A performs a switching process (S14), and then ends the process.

Specifically, the switching process is processed as shown in FIG. 13. First, in FIG. 13, input device 100A determines whether or not a touch on switches 203 and 204 is performed at a single location (S141). When it is determined that a touch on switches 203 and 204 is performed at more than a single location (No in S141), input device 100A determines the operation-target switch (S143) and an operation for the determined switch (S144). In this exemplary embodiment, there are two switches: switches 203 and 204, and a case where a touch on switches 203 and 204 is performed at more than a single location means that the two switches are simultaneously touched at two locations. At this time, as described above, input device 100A determines an operation, such as a tap input, on switch 203 touched with a tip of a finger or thumb. This operation uses a fact that, when a tap operation is performed on switch 203, another tap operation is unintentionally performed on switch 204 with a base of the finger, and thus switch 204 is simultaneously touched. In other words, when input device 100A detects such simultaneous tap operations, input device 100A determines that the tap input on switch 203 is intended. When driver 50 intentionally performs a tap operation on switch 204, driver 50 bends a finger to perform the tap operation. Therefore, switch 203 will not unintentionally and simultaneously be touched because of their locations. As a result, when input device 100A detects a tap operation from switch 204 only, input device 100A determines that a tap input on switch 204 is intended.

On the other hand, when input device 100A determines that a touch on switches 203 and 204 is performed at a single location (Yes in S141), input device 100A determines whether or not there is an operation such as a tap input on switch 203 or 204 (S142). When input device 100A determines that a tap input is operated (Yes in S142), input device 100A determines the operation on switch 203 or 204 (S144). When input device 100A does not determine that a tap input is operated (No in S142), input device 100A returns to the operation of S142 to wait until input device 100A determines that a tap input is operated.

In addition, in FIG. 11, when input device 100A determines that a finger or thumb is consecutively touching the element configuring home location identification part 202 for the certain period of time (Yes in S11), input device 100A determines whether or not a plurality of elements forming a range wider than a width of a finger or thumb are simultaneously touched in addition to home location identification part 202 (S15).

In S15, when input device 100A determines that a finger or thumb does not simultaneously touch home location identification part 202 and the plurality of elements forming the range wider than a width of a finger or thumb (No in S15), input device 100A operates as described below. That is, input device 100A determines whether or not a tip of a finger or thumb touches switch 203 via home location identification part 202 (S16) by stretching the finger or thumb after input device 100A has validated an input operation when the finger or thumb has touched home location identification part 202.

When input device 100A does not determine that the finger or thumb has touched switch 203 via home location identification part 202 (No in S16) after the finger or thumb has touched home location identification part 202, input device 100A performs a sliding process (S17), and then ends the process.

The sliding process will be specifically described with reference to FIG. 14. First, input device 100A determines whether or not a finger or thumb has moved from home location identification part 202 to an element includes in slider 201 (S171). When input device 100A determines that the finger or thumb has not been moved from home location identification part 202 to the element of slider 201 (No in S171), input device 100A determines whether or not a certain period of time has passed (S172). The certain period of time is a period of time from when home location identification part 202 is touched by a finger or thumb, to when no subsequent input operation has been performed and any further input operation is invalidated. Specifically, the certain period of time is a period of time, such as one second counted from when input device 100A has started to execute the processes of the flowchart shown in FIG. 14, and is measured by input device 100A. When the certain period of time has passed (Yes in S172), any input operation is invalidated and input device 100A ends this sliding process. If the certain period of time has not yet passed (No in S172), input device 100A returns to S171 to wait until the certain period of time has passed.

On the other hand, in S171, when input device 100A determines that the finger or thumb has moved from home location identification part 202 to the element of slider 201 (Yes in S171), input device 100A performs a process as described below. First, input device 100A determines whether or not the finger or thumb has been moved on slider 201 (S173). Specifically, input device 100A determines whether or not a movement of the finger or thumb on slider 201 satisfies a threshold determined based on a predetermined speed or a predetermined distance.

When input device 100A determines that the finger or thumb has been moved on slider 201 (Yes in S173), input device 100A obtains a coordinate of slider 201 onto which the finger or thumb has moved, outputs a result to, for example, controller 32 (S174), and allows the process to proceed to S175. On the other hand, when input device 100A determines that the finger or thumb has not been moved on slider 201 (No in S173), input device 100A causes the process to proceed to S175.

Next, input device 100A determines whether or not the finger or thumb has been removed from slider 201. If the finger or thumb has not been removed from slider 201 (No in S175), input device 100A causes the process to proceed to S176. On the other hand, when input device 100A determines that the finger or thumb has been removed from slider 201 (Yes in S175), input device 100A determines that an operation with the finger or thumb has been determined, and allows the process to proceed to S177.

In S176, input device 100A determines whether or not a certain period of time has passed while the finger or thumbs is not removed from slider 201 and remains touched. The certain period of time is, as described in S172, a period of time, such as one second counted from when input device 100A has started to execute the processes of the flowchart shown in FIG. 14, and is measured by input device 100A. If the certain period of time has not yet passed (No in S176), the finger or thumb will possibly perform another consecutive operation. Therefore, input device 100A causes the process to return to S173. On the other hand, when the certain period of time has passed (Yes in S176), input device 100A determines that the operation with the finger or thumb has been determined, and allows the process to proceed to S177.

In S177, input device 100A determines the coordinate of slider 201 obtained in S174, or determines that a flick operation is performed once, and outputs a result to, for example, controller 32. Input device 100A then determines whether or not a certain period of time has passed (S178). The certain period of time is, as described in S172, a period of time, such as one second counted from when input device 100A has started to execute the processes of the flowchart shown in FIG. 14, and is measured by input device 100A. If the certain period of time has not yet passed (No in S178), the finger or thumb will possibly perform another consecutive operation. Therefore, input device 100A causes the process to return to S173. On the other hand, when the certain period of time has passed (Yes in S178), input device 100A determines that the operation with the finger or thumb has finished, and ends the sliding process as well.

In S15 in FIG. 11, when input device 100A determines that a finger, a thumb, or another object has simultaneously touched home location identification part 202 and a plurality of elements forming the range wider than a width of a finger or thumb (Yes in S15), input device 100A performs a gripping process (S18), and then ends this input process. Specifically, as shown in FIG. 15, in the gripping process, input device 100A performs a process for canceling the operation (S181). This gripping process corresponds to, for example, as described above, a process for finishing a first operation on slider 201 by simultaneously touching a plurality of detection locations with a finger, a thumb, or another object.

With the input device and the input method according to this exemplary embodiment described above, an erroneous input can be reduced even when a driver performs an input while holding a steering wheel.

Specifically, the input device according to this exemplary embodiment includes a touch sensor provided at a predetermined location of a circular part (rim) of the steering wheel. Furthermore, this touch sensor is provided with a home location identification part (operation commencement trigger part) served as a start point of a first operation, such as a flick operation and a slide operation. Around this home location identification part, a slider capable of detecting a flick operation, and a switch capable of detecting a tap input are provided. With the input device according to this exemplary embodiment configured as described above, input operations including a slide operation, a flick operation, and a tap operation can be achieved.

In addition, in order to , consecutively repeat flick operations or slide operations after an input operation has been validated, a driver is not required to start an input operation from the home location identification part. Therefore, an erroneous input can be reduced, and the driver can smoothly touch-input an operation without seeing the input device.

### (First exemplary modification)

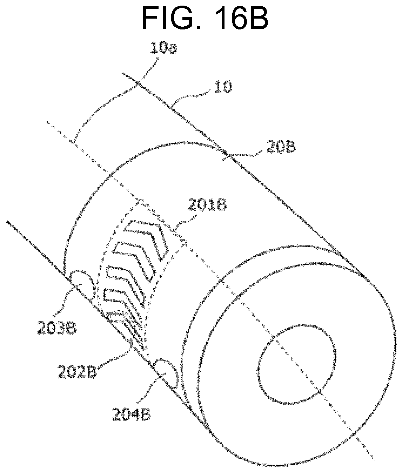

FIG. 16A is a view illustrating an example of steering wheel 10 provided with touch sensor 20B according to a first exemplary modification of this exemplary embodiment. FIG. 16B is a view illustrating a positional relationship between touch sensor 20B and steering wheel 10 shown in FIG. 16A. In FIG. 16A and FIG. 16B, cover 11 has been omitted for simply illustrating touch sensor 20B.

In the above described exemplary embodiment, touch sensor 20A is disposed, in other words, slider 201, switch 203, and switch 204 are disposed at the predetermined location(s) (location(s), facing driver 50, of the circular part of steering wheel 10) shown in FIG. 6A and FIG. 6B. However, other locations may be applied. As shown in FIG. 16A and FIG. 16B, a plurality of elements of slider 201B may be disposed side by side in a direction substantially perpendicular to a direction toward which the circular part turns, as well as at least one element among the plurality of elements may be disposed inside the circular part.

In other words, slider 201B includes the plurality of elements each for detecting an electrostatic capacitance. The plurality of elements included in slider 201B is disposed in a direction substantially perpendicular to axis 10a extending in a circumference direction of the circular part of steering wheel 10, as well as disposed inside the circular part. Specifically, as shown in FIG. 16B, at least one of the plurality of arranged elements is disposed in a direction perpendicular to axis 10a of the circular part, and along an inner surface of the circular part. The direction substantially perpendicular to axis 10a is defined to a direction perpendicular to axis 10a in a range within which a driver is able to easily perform a flick operation and a slide operation on the plurality of elements, and is predetermined in accordance with a vehicle type and a size of steering wheel 10.

When driver 50 turns steering wheel 10, driver 50 may apply a larger force to steering wheel 10 with his or her hand, or driver 50 may quickly turn steering wheel 10.

In this case, when uneven parts or different tactile parts are provided on home location identification part 202 and switch 203, driver 50 might feel uncomfortable when he or she turns steering wheel 10. In this exemplary modification, slider 201B, home location identification part 202B, switch 203B, and switch 204B are provided inside the circular part of steering wheel 10. Therefore, while turning steering wheel 10, driver 50 is less likely to touch any or all of the slider, home location identification part, and switches, thus driver 50 can easily turn steering wheel 10.

In FIG. 16B, slider 201B is wholly disposed inside the circular part of steering wheel 10. However, by assuming that home location identification part 202B and uneven parts are disposed inside the circular part, a few elements, for example, may be disposed outside the circular part. In this case, the plurality of elements are disposed on a surface of the circular part from inside to outside.

### (Second exemplary modification)

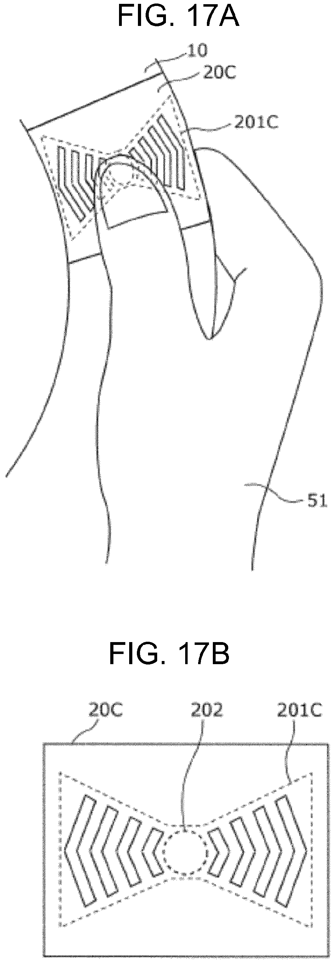

FIG. 17A is a view illustrating an example when a flick operation is performed on touch sensor 20C according to a second exemplary modification of this exemplary embodiment. FIG. 17B is a view illustrating an appearance of touch sensor 20C shown in FIG. 17A. In FIG. 17A, cover 11 is omitted for simply illustrate touch sensor 20C.

In the above described exemplary embodiment, as shown in FIG. 6A and FIG. 6B, the plurality of elements included in slider 201 is disposed side by side in the direction substantially perpendicular to the direction toward which the circular part turns. However another arrangement may be applied. As shown in FIG. 17A, a plurality of elements included in slider 201C may be disposed side by side in directions each substantially perpendicular to a direction toward which the circular part of steering wheel 10 turns so as to each expand in a fan shape. In other words, as shown in FIG. 17B, home location identification part 202 is provided at a center of slider 201C in a width direction, and the plurality of elements is disposed to expand in fan shapes around home location identification part 202.

More specifically, slider 201C includes the plurality of elements each for detecting an electrostatic capacitance, and home location identification part 202 is provided at the center of slider 201C in the width direction. In this case, the plurality of elements is disposed side by side in the directions each substantially perpendicular to the direction toward which the circular part of steering wheel 10 turns so as to each expand in the fan shape around home location identification part 202.

The fan shape may not be limited to the shape where the plurality of elements expands in both left and right directions from home location identification part 202, but may be a fan shape where the plurality of elements expands in either the directions only. In addition, a central angle of the fan shape may be set as desired to a maximum of 90° when the direction perpendicular to the axis of the circular part is specified to 0°. This angle is set and determined depending on a location of touch sensor 20C disposed on the circular part and the size of steering wheel 10 so that driver 50 is easily able to perform various operations with a tip of his or her finger or thumb. In a case where a switch is provided on touch sensor 20C, the switch is disposed at a location with which slider 201C having fan shapes is not interfered.

Therefore, since a degree of freedom in angle within which driver 50 is able to move his or her finger or thumb from home location identification part 202 on the circular part increases, driver 50 is able to smoothly move his or her finger or thumb to perform an operation on slider 201C. In addition, an individual difference in a direction toward which driver 50 slides his or her finger or thumb can be compensated.

FIG. 17A, FIG. 17B have exemplified that the plurality of elements of slider 201C expands in the fan shapes. However, the fan shapes are not essential, but the plurality of elements may expand in, for example, a nonlinear shape, such as a round fan shape. As described above, slider 201C may at least have a shape that expands more as the distance from home location identification part 202 is lager.

### (Third exemplary modification)

In the above described exemplary embodiment, touch sensor 20A is provided at the predetermined location, which is a right side of steering wheel 10, when viewed from a driver. However, touch sensor 20A may be provided at another location. Touch sensor 20A may be provided on a left side of steering wheel 10, or touch sensors 20A may be provided on the left and right sides of steering wheel 10. When touch sensors 20A are provided on the left and right sides, touch sensors 20A on the left and right sides may be combined to configure an operation, such as a flick operation.

The input device and the input method for the input device according to the present invention have been described based on the exemplary embodiment. However, the present invention is not limited to this exemplary embodiment. Various modifications to this exemplary embodiment, and various forms configured by combining the components in different exemplary embodiments, which can be devised by those skilled in the art, are included in the scope of the present invention.

### INDUSTRIAL APPLICABILITY

The present invention is applicable to vehicles provided with a ring-shaped steering wheel, and, in particular, an input device and an input method for the input device provided in a vehicle such as a car.

### REFERENCE MARKS IN THE DRAWINGS

10: steering wheel
10a: axis
11: cover
20, 20A, 20B, 20C: touch sensor
21: touch sensor area
22: detection circuit
30: on-vehicle device
31: audio player
32: controller
33: loudspeaker
40: seat
50: driver
51, 52: hand
60: grip sensor
100, 100A: input device
201, 201B, 201C: slider
201a, 201b, 201c, 201d, 201e, 201f: element
202, 202B: home location identification part
203, 203B, 204, 204B: switch

## Claims

1. An input device (100) comprising:
an operation part (20A) provided on a surface of the circular part of a steering wheel (10) and including a slider (201) of an electrostatic capacity type;
an operation commencement trigger part (202), provided at a predetermined location on the slider (201), for commencing a first operation including a flick operation on the slider (201); and
a detection circuit (22) for enabling, upon detecting that the operation commencement trigger part (202) has been touched, detection of the first operation on the slider (201),
wherein the slider (201) includes a plurality of elements (201a, ..., 201f) each for detecting an electrostatic capacitance, and
the detection circuit (22) detects that the first operation has finished when, among the plurality of elements (201a, ..., 201f), at least a predetermined number of elements has approximately simultaneously detected an electrostatic capacitance equal to or greater than a threshold for a second predetermined period of time.

2. The input device according to claim 1, wherein the slider (201) is disposed at a predetermined location on the circular part when the steering wheel (10) lies at a neutral position, and extends in a direction substantially perpendicular to a direction toward which the circular part turns.

3. The input device according to claim 1, wherein the slider (201) includes a plurality of elements (201a, ..., 201f) each for detecting an electrostatic capacitance, and the plurality of elements (201a, ..., 201f) is disposed side by side in a direction substantially perpendicular to a direction toward which the circular part turns.

4. The input device according to claim 3, wherein
the operation commencement trigger part (202) includes, among the plurality of elements (201a, ..., 201f), at least one element belonging to an area including the predetermined location on the slider (201), and
the detection circuit (22) detects that, when the at least one element detects an electrostatic capacitance equal to or greater than a threshold, the operation commencement trigger part (202) has been touched.

5. The input device according to claim 3, wherein
the operation commencement trigger part (202) includes, among the plurality of elements (201a, ..., 201f), at least one element belonging to an area including the predetermined location on the slider (201), and
the detection circuit (22) detects that, when the at least one element detects an electrostatic capacitance equal to or greater than a threshold for a predetermined period of time or longer, the operation commencement trigger part (202) has been touched.

6. The input device according to claim 1, wherein
the slider (201) includes a plurality of elements (201a, ..., 201f) each for detecting an electrostatic capacitance,
the operation commencement trigger part (202) is provided at a center of the slider (201) in a direction toward which a finger or thumb is slid, and
the plurality of elements (201a, ..., 201f) is disposed side by side in a direction substantially perpendicular to a direction toward which the circular part turns so as to expand in a fan shape around the operation commencement trigger part (202).

7. The input device according to claim 1, wherein
the slider (201) includes a plurality of elements (201a, ..., 201f) each for detecting an electrostatic capacitance, the plurality of elements (201a, ..., 201f) being disposed side by side in a direction substantially perpendicular to a direction toward which the circular part turns, and
at least one element among the plurality of elements (201a, ..., 201f) is disposed inside the circular part.

8. The input device according to claim 1, further comprising a switch (203, 204) disposed at a predetermined location away from the operation commencement trigger part (202) in a circumferential direction of the circular part,
wherein the switch (023, 204) includes an electrostatic capacity-type touch sensor and is configured to accept a second operation including a tap operation.

9. The input device according to claim 8, wherein, after enabling detection of the first operation, when detecting the second operation on the switch (203, 204), the detection circuit (22) detects that the first operation has finished.

10. The input device according to claim 1, further comprising a grip sensor (60) for detecting that the steering wheel (10) has been gripped,
wherein the grip sensor (60) is disposed on the circular part at a location different from the location of the slider (201).

11. The input device according to claim 10, wherein
the grip sensor (60) further identifies a location at which the steering wheel (10) has been gripped when the steering wheel (10) has been gripped, and
the detection circuit (22) disables detection of the first operation on the slider (201) when the location identified by the grip sensor (60) is the location of the slider (201) disposed on the circular part.

12. The input device according to claim 10, wherein
the grip sensor (60) further identifies a first location at which the steering wheel (10) has been gripped when the steering wheel (10) has been gripped, and
the detection circuit (22) enables detection of the first operation on the slider (201) when a second location estimated from an interrelationship with the first location obtained beforehand based on the first location identified by the grip sensor (60) is the location at which the slider (201) is disposed.

13. The input device according to claim 1, wherein
the slider (201) includes a plurality of elements (201a, ..., 201f) each for detecting an electrostatic capacitance, and
the detection circuit (22) detects that the first operation has finished when the plurality of elements (201a, ..., 201f) detects an electrostatic capacitance smaller than a threshold for a first predetermined period of time or longer.

14. The input device according to claim 1, further comprising a cover covering the slider (201),
wherein, at a location of the cover covering the operation commencement trigger part (202), at least one of an uneven part, an illumination part, and a different tactile part from other parts of the cover is provided.

15. The input device according to claim 1, wherein, at a location of the operation commencement trigger part (202) disposed on the slider (201), at least one of an uneven part, an illumination part, and a different tactile part from other parts of the slider (201) is provided.

16. An input method for an input device including an operation part provided on a surface of the circular part of a steering wheel (10) and including a slider (201) having a plurality of elements (201a, ..., 201f) each for detecting an electrostatic capacity type and an operation commencement trigger part (202) provided at a predetermined location on the slider (201), the input method comprising:
detecting whether or not the operation commencement trigger part (202) has been touched; and
enabling detection of a first operation on the slider (201) when a fact that the operation commencement trigger part (202) has been touched is detected
detecting that the first operation has finished when, among the plurality of elements (201a, ..., 201f), at least a predetermined number of elements has approximately simultaneously detected an electrostatic capacitance equal to or greater than a threshold for a second predetermined period of time.

## Patentansprüche

1. Eingabevorrichtung (100), aufweisend:
einen Betätigungsteil (20A), der auf einer Fläche des kreisförmigen Teils eines Lenkrads (10) vorgesehen ist und einen Schieber (201) eines elektrostatischen Kapazitätstyps enthält;
einen Betätigungsbeginn-Auslöseteil (202), der an einer im Voraus bestimmten Stelle auf dem Schieber (201) vorgesehen ist, um eine erste, eine Wischbetätigung umfassende Betätigung auf dem Schieber (201) zu beginnen; und
eine Erfassungsschaltung (22) zum Ermöglichen des Erfassens der ersten Betätigung des Schiebers (201), nachdem erfasst worden ist, dass der Betätigungsbeginn-Auslöseteil (202) berührt worden ist;
wobei der Schieber (201) mehrere Elemente (201a, ..., 201f), jeweils zum Erfassen einer elektrostatischen Kapazität, umfasst, und
die Erfassungsschaltung (22) erfasst, dass die erste Betätigung beendet ist, wenn unter den mehreren Elementen (201a, ..., 201f) mindestens eine im Voraus bestimmte Anzahl von Elementen ungefähr gleichzeitig eine elektrostatische Kapazität erfasst hat, die gleich groß wie oder größer als ein Schwellenwert einer zweiten im Voraus bestimmten Zeitperiode ist.

2. Eingabevorrichtung nach Anspruch 1, wobei der Schieber (201) an einer im Voraus bestimmten Stelle auf dem kreisförmigen Teil angeordnet ist, wenn sich das Lenkrad (10) in einer neutralen Position befindet, und sich in einer Richtung erstreckt, die im Wesentlichen senkrecht zu einer Richtung ist, in die sich der kreisförmige Teil dreht.

3. Eingabevorrichtung nach Anspruch 1, wobei der Schieber (201) mehrere Elemente (201a, ..., 201f), jeweils zum Erfassen einer elektrostatischen Kapazität, umfasst, und die mehreren Elemente (201a, ..., 201f) Seite an Seite in einer Richtung angeordnet sind, die im Wesentlichen senkrecht zu einer Richtung ist, in die sich der kreisförmige Teil dreht.

4. Eingabevorrichtung nach Anspruch 3, wobei
der Betätigungsbeginn-Auslöseteil (202) unter den mehreren Elementen (201a, ..., 201f) mindestens ein Element umfasst, das zu einem Bereich gehört, der eine im Voraus bestimmte Stelle auf dem Schieber (201) umfasst, und
die Erfassungsschaltung (22) erfasst, dass, wenn das mindestens eine Element eine elektrostatische Kapazität erfasst, die gleich groß wie oder größer als ein Schwellenwert ist, der Betätigungsbeginn-Auslöseteil (202) berührt worden ist.

5. Eingabevorrichtung nach Anspruch 3, wobei
der Betätigungsbeginn-Auslöseteil (202) unter den mehreren Elementen (201a, ..., 201f) mindestens ein Element umfasst, das zu einem Bereich gehört, der eine im Voraus bestimmte Stelle auf dem Schieber (201) umfasst, und
die Erfassungsschaltung (22) erfasst, dass, wenn das mindestens eine Element eine elektrostatische Kapazität erfasst, die gleich groß wie oder größer als ein Schwellenwert einer im Voraus bestimmten Zeitperiode ist, der Betätigungsbeginn-Auslöseteil (202) berührt worden ist.

6. Eingabevorrichtung nach Anspruch 1, wobei
der Schieber (201) mehrere Elemente (201a, ..., 201f), jeweils zum Erfassen einer elektrostatischen Kapazität, umfasst,
der Betätigungsbeginn-Auslöseteil (202) in einer Mitte des Schiebers (201) in einer Richtung vorgesehen ist, in die ein Finger oder Daumen geschoben wird, und
die mehreren Elemente (201a, ..., 201f) Seite an Seite in einer Richtung angeordnet sind, die im Wesentlichen senkrecht zu einer Richtung ist, in die sich der kreisförmige Teil dreht, so dass er sich in einer Fächerform um den Betätigungsbeginn-Auslöseteil (202) herum ausdehnt.

7. Eingabevorrichtung nach Anspruch 1, wobei
der Schieber (201) mehrere Elemente (201a, ..., 201f), jeweils zum Erfassen einer elektrostatischen Kapazität, umfasst, die mehreren Elemente (201a, ..., 201f) Seite an Seite in einer Richtung angeordnet sind, die im Wesentlichen senkrecht zu einer Richtung ist, in die sich der kreisförmige Teil dreht, und
mindestens eines unter den mehreren Elementen (201a, ..., 201f) auf der Innenseite des kreisförmigen Teils angeordnet ist.

8. Eingabevorrichtung nach Anspruch 1, ferner aufweisend einen Schalter (203, 204), der an einer im Voraus bestimmten Stelle entfernt vom Betätigungsbeginn-Auslöseteil (202) in einer Umfangsrichtung des kreisförmigen Teils angeordnet ist,
wobei der Schalter (203, 204) einen Berührungssensor vom elektrostatischen Kapazitätstyp umfasst und für ein Annehmen einer zweite Betätigung einschließlich einer Tippbetätigung konfiguriert ist.

9. Eingabevorrichtung nach Anspruch 8, wobei nach Ermöglichen des Erfassens der ersten Betätigung, wenn die zweite Betätigung des Schalters (203, 204) erfasst wird, die Erfassungsschaltung (22) erfasst, dass die erste Betätigung beendet ist.

10. Eingabevorrichtung nach Anspruch 1, ferner aufweisend einen Griffsensor (60) zum Erfassen, dass das Lenkrad (10) gegriffen ist,
wobei der Griffsensor (60) auf dem kreisförmigen Teil an einer Stelle angeordnet ist, die sich von der Stelle des Schiebers (201) unterscheidet.

11. Eingabevorrichtung nach Anspruch 10, wobei
der Griffsensor (60) ferner eine Stelle identifiziert, an der das Lenkrad (10) gegriffen wurde, wenn das Lenkrad (10) gegriffen worden ist, und
die Erfassungsschaltung (22) das Erfassen der ersten Betätigung des Schiebers (201) deaktiviert, wenn die vom Griffsensor (60) identifizierte Stelle die Stelle ist, an der der Schieber (201) auf dem kreisförmigen Teil angeordnet ist.

12. Eingabevorrichtung nach Anspruch 10, wobei
der Griffsensor (60) ferner eine erste Stelle identifiziert, an der das Lenkrad (10) gegriffen wurde, wenn das Lenkrad (10) gegriffen worden ist, und
die Erfassungsschaltung (22) das Erfassen der ersten Betätigung des Schiebers (201) aktiviert, wenn eine zweite Stelle, geschätzt anhand einer Wechselbeziehung zur ersten Stelle, die im Voraus auf der Grundlage der ersten durch den Greifsensor (60) identifizierten Stelle erhalten worden ist, die Stelle ist, an der der Schieber (201) angeordnet ist.

13. Eingabevorrichtung nach Anspruch 1, wobei
der Schieber (201) mehrere Elemente (201a, ..., 201f), jeweils zum Erfassen einer elektrostatischen Kapazität, umfasst, und
die Erfassungsschaltung (22) erfasst, dass die erste Betätigung beendet ist, wenn die mehreren Elemente (201a, ..., 201f) eine elektrostatische Kapazität erfassen, die niedriger als ein Schwellenwert einer ersten im Voraus bestimmten Zeitperiode oder länger ist.

14. Eingabevorrichtung nach Anspruch 1, ferner aufweisend eine Abdeckung, die den Schieber (201) abdeckt,
wobei an einer Stelle der Abdeckung, die den Betätigungsbeginn-Auslöseteil (202) abdeckt, mindestens eines von einem unebenen Teil, einem Beleuchtungsteil und einem anderen, sich von anderen Teilen der Abdeckung unterscheidenden taktilen Teil vorgesehen ist.

15. Eingabevorrichtung nach Anspruch 1, wobei, an einer Stelle des auf dem Schieber (201) angeordneten Betätigungsbeginn-Auslöseteils (202), mindestens eines von einem unebenen Teil, einem Beleuchtungsteil und einem anderen, sich von anderen Teilen der Abdeckung unterscheidenden taktilen Teil vorgesehen ist.

16. Eingabeverfahren für eine Eingabevorrichtung, aufweisend einen auf einer Fläche des kreisförmigen Teils eines Lenkrads (10) vorgesehenen Betätigungsteil und einen Schieber (201), umfassend mehrere Elemente (201a, ..., 201f), jeweils zum Erfassen eines elektrostatischen Kapazitätstyps, und einen an einer im Voraus bestimmten Stelle auf dem Schieber (201) vorgesehenen Betätigungsbeginn-Auslöseteil (202), wobei das Eingabeverfahren Folgendes umfasst:
Erfassen, ob der Betätigungsbeginn-Auslöseteil (202) berührt worden ist oder nicht; und
Ermöglichen des Erfassens einer ersten Betätigung des Schiebers (201), wenn eine Tatsache, dass der Betätigungsbeginn-Auslöseteil (202) berührt worden ist, erfasst wird,
Erfassen, dass die erste Betätigung beendet ist, wenn unter den mehreren Elementen (201a, ..., 201f) mindestens eine im Voraus bestimmte Anzahl von Elementen ungefähr gleichzeitig eine elektrostatische Kapazität erfasst hat, die gleich groß wie oder größer als ein Schwellenwert einer zweiten im Voraus bestimmten Zeitperiode ist.

## Revendications

1. Dispositif d'entrée (100) qui comprend :
une partie d'opération (20A) prévue sur une surface de la partie circulaire d'un volant (10) et qui comprend un coulisseau (201) d'un type à capacité électrostatique ;
une partie de déclenchement de début d'opération (202), prévue à un emplacement prédéterminé sur le coulisseau (201), pour débuter une première opération qui comprend une opération de pression sur le coulisseau (201) ; et
un circuit de détection (22) pour permettre, lors de la détection que la partie de déclenchement de début d'opération (202) a été touchée, la détection de la première opération sur le coulisseau (201),
dans lequel le coulisseau (201) comprend une pluralité d'éléments (201a, ..., 201f), chacun pour détecter une capacitance électrostatique, et
le circuit de détection (22) détecte que la première opération est terminée lorsque, parmi la pluralité d'éléments (201a, ..., 201f), au moins un nombre prédéterminé d'éléments ont détecté à peu près simultanément une capacitance électrostatique supérieure ou égale à un seuil pendant une deuxième période de temps prédéterminée.

2. Dispositif d'entrée selon la revendication 1, dans lequel le coulisseau (201) est disposé à un emplacement prédéterminé sur la partie circulaire lorsque le volant (10) se trouve à une position neutre, et s'étend dans une direction sensiblement perpendiculaire à une direction vers laquelle la partie circulaire tourne.

3. Dispositif d'entrée selon la revendication 1, dans lequel le coulisseau (201) comprend une pluralité d'éléments (201a, ..., 201f), chacun pour détecter une capacitance électrostatique, et la pluralité d'éléments (201a, ..., 201f) sont disposés côte à côte dans une direction sensiblement perpendiculaire à une direction vers laquelle la partie circulaire tourne.

4. Dispositif d'entrée selon la revendication 3, dans lequel
la partie de déclenchement de début d'opération (202) comprend, parmi la pluralité d'éléments (201a, ..., 201f), au moins un élément qui appartient à une zone qui comprend l'emplacement prédéterminé sur le coulisseau (201), et
le circuit de détection (22) détecte que, lorsque ledit au moins un élément détecte une capacitance électrostatique supérieure ou égale à un seuil, la partie de déclenchement de début d'opération (202) a été touchée.

5. Dispositif d'entrée selon la revendication 3, dans lequel
la partie de déclenchement de début d'opération (202) comprend, parmi la pluralité d'éléments (201a, ..., 201f), au moins un élément qui appartient à une zone qui comprend l'emplacement prédéterminé sur le coulisseau (201), et
le circuit de détection (22) détecte que, lorsque ledit au moins un élément détecte une capacitance électrostatique supérieure ou égale à un seuil pendant une période de temps prédéterminée ou plus longue, la partie de déclenchement de début d'opération (202) a été touchée.

6. Dispositif d'entrée selon la revendication 1, dans lequel
le coulisseau (201) comprend une pluralité d'éléments (201a, ..., 201f), chacun pour détecter une capacitance électrostatique,
la partie de déclenchement de début d'opération (202) est prévue au niveau d'un centre du coulisseau (201) dans une direction vers laquelle un doigt ou un pouce est déplacé, et
la pluralité d'éléments (201a, ..., 201f) sont disposés côte à côte dans une direction sensiblement perpendiculaire à une direction vers laquelle la partie circulaire tourne de manière à s'étendre en une forme d'éventail autour de la partie de déclenchement de début d'opération (202).

7. Dispositif d'entrée selon la revendication 1, dans lequel
le coulisseau (201) comprend une pluralité d'éléments (201a, ..., 201f), chacun pour détecter une capacitance électrostatique, dans lequel la pluralité d'éléments (201a, ..., 201f) sont disposés côte à côte dans une direction sensiblement perpendiculaire à une direction vers laquelle la partie circulaire tourne, et
au moins un élément parmi la pluralité d'éléments (201a, ..., 201f) est disposé à l'intérieur de la partie circulaire.

8. Dispositif d'entrée selon la revendication 1, qui comprend en outre un commutateur (203, 204) disposé à un emplacement prédéterminé à distance de la partie de déclenchement de début d'opération (202) dans une direction circonférentielle de la partie circulaire,
dans lequel le commutateur (203, 204) comprend un capteur tactile de type à capacité électrostatique et est configuré pour recevoir une deuxième opération qui comprend une opération de prise.

9. Dispositif d'entrée selon la revendication 8, dans lequel, après avoir autorisé la détection de la première opération, lors de la détection de la deuxième opération sur le commutateur (203, 204), le circuit de détection (22) détecte que la première opération est terminée.

10. Dispositif d'entrée selon la revendication 1, qui comprend en outre un capteur de préhension (60) pour détecter que le volant (10) a été saisi,
dans lequel le capteur de préhension (60) est disposé sur la partie circulaire à un emplacement différent de l'emplacement du coulisseau (201).

11. Dispositif d'entrée selon la revendication 10, dans lequel
le capteur de préhension (60) identifie en outre un emplacement auquel le volant (10) a été saisi lorsque le volant (10) a été saisi, et
le circuit de détection (22) désactive la détection de la première opération sur le coulisseau (201) lorsque l'emplacement identifié par le capteur de préhension (60) est l'emplacement du coulisseau (201) disposé sur la partie circulaire.

12. Dispositif d'entrée selon la revendication 10, dans lequel
le capteur de préhension (60) identifie en outre un premier emplacement auquel le volant (10) a été saisi lorsque le volant (10) a été saisi, et
le circuit de détection (22) autorise la détection de la première opération sur le coulisseau (201) lorsqu'un deuxième emplacement estimé à partir d'une relation réciproque avec le premier emplacement obtenu au préalable sur la base du premier emplacement identifié par le capteur de préhension (60) est l'emplacement auquel le coulisseau (201) est disposé.

13. Dispositif d'entrée selon la revendication 1, dans lequel
le coulisseau (201) comprend une pluralité d'éléments (201a, ..., 201f), chacun pour détecter une capacitance électrostatique, et
le circuit de détection (22) détecte que la première opération est terminée lorsque la pluralité d'éléments (201a, ..., 201f) détectent une capacitance électrostatique inférieure à un seuil pendant une première période de temps prédéterminée ou plus longue.

14. Dispositif d'entrée selon la revendication 1, qui comprend en outre un capot qui recouvre le coulisseau (201),
dans lequel, à un emplacement du capot qui recouvre la partie de déclenchement de début d'opération (202), au moins l'une d'une partie irrégulière, d'une partie d'éclairage et d'une partie tactile différente des autres parties du capot est prévue.

15. Dispositif d'entrée selon la revendication 1, dans lequel, à un emplacement de la partie de déclenchement de début d'opération (202) disposée sur le coulisseau (201), au moins l'une d'une partie irrégulière, d'une partie d'éclairage et d'une partie tactile différente des autres parties du coulisseau (201) est prévue.

16. Procédé d'entrée pour un dispositif d'entrée qui comprend une partie d'opération prévue sur une surface de la partie circulaire d'un volant (10) et qui comprend un coulisseau (201) qui comporte une pluralité d'éléments (201a, ..., 201f), chacun pour détecter un type de capacité électrostatique, et une partie de déclenchement de début d'opération (202) prévue à un emplacement prédéterminé sur le coulisseau (201), dans lequel le procédé d'entrée comprend :
la détection si, oui ou non, la partie de déclenchement de début d'opération (202) a été touchée ; et
l'autorisation de la détection d'une première opération sur le coulisseau (201) lors de la détection que la partie de déclenchement de début d'opération (202) a été touchée ;
la détection que la première opération est terminée lorsque, parmi la pluralité d'éléments (201a, ..., 201f), au moins un nombre prédéterminé d'éléments ont détecté à peu près simultanément une capacitance électrostatique supérieure ou égale à un seuil pendant une deuxième période de temps prédéterminée.
